# EUROPÄISCHE PATENTSCHRIFT

(11) **EP 2 705 546 B1**
(45) Veröffentlichungstag und Bekanntmachung des Hinweises auf die Patenterteilung: **04.03.2020**
(21) Anmeldenummer: 12714268.5
(22) Anmeldetag: 28.03.2012
(51) Int. Cl.: H01L 33/56, H01L 33/50, H01L 33/44

(54) **OPTOELEKTRONISCHES HALBLEITERBAUELEMENT**
OPTOELECTRONIC SEMICONDUCTOR DEVICE
DISPOSITIF OPTOÉLECTRONIQUE À SEMI-CONDUCTEURS

(30) Priorität: 06.05.2011 DE 102011100728
(43) Veröffentlichungstag der Anmeldung: 12.03.2014
(73) Patentinhaber: OSRAM Opto Semiconductors GmbH, 93055 Regensburg (DE)
(72) Erfinder: KRÄUTER, Gertrud, 93051 Regensburg (DE)
(74) Vertreter: Epping - Hermann - Fischer
(86) Internationale Anmeldenummer: PCT/EP2012/055552
(87) Internationale Veröffentlichungsnummer: WO 2012/152502

(56) Entgegenhaltungen:
- WO-A1-2011/105185
- WO-A2-2012/067766
- DE-A1-102008 020 324
- US-A1- 2008 067 918
- US-A1- 2008 303 044
- ILARIA MENAPACE ET AL: "Luminescence of heat-treated silicon-based polymers: promising materials for LED applications", JOURNAL OF MATERIALS SCIENCE, KLUWER ACADEMIC PUBLISHERS, BO, Bd. 43, Nr. 17, 5. August 2008 (2008-08-05), Seiten 5790-5796, XP019607692, ISSN: 1573-4803

## Beschreibung

Eine zu lösende Aufgabe besteht darin, ein optoelektronisches Halbleiterbauelement anzugeben, welches alterungsstabil ist. Die Druckschrift US 2008/0303044 A1 offenbart eine LED-Anordnung, bei der Polysilazan als Ausgangsmaterial ("Precursor") zur Herstellung eines Verkapselungsmaterials verwendet wird, das dem LED-Chip nachgeordnet ist.

Die Druckschrift US 2008/0067918 A1 offenbart eine LED-Anordnung mit einer dem LED-Chip nachgeordneten Phosphorschicht, die als Bindemittel ein Polysilazan enthält. In der Druckschrift DE 10 2008 020 324 A1 wird eine Polysilazan-Beschichtung für Oberflächen von Solarzellen angegeben.

In der Druckschrift WO 2012/067766 A2, die Stand der Technik gemäß Artikel 54(3) EPÜ ist, ist ein optoelektronisches Halbleiterbauteil angegeben, das eine oder mehrere Anhaftschichten aus Polysilazan enthält.

Die vorliegende Erfindung ist in Anspruch 1 definiert. Gemäß der vorliegenden Erfindung umfasst das optoelektronische Halbleiterbauelement zumindest einen strahlungsemittierenden Halbleiterchip, der eine Strahlungsauskoppelfläche aufweist, durch die zumindest ein Teil der im Halbleiterchip erzeugten elektromagnetischen Strahlung den Halbleiterchip verlässt. Bei dem strahlungsemittierenden Halbleiterchip kann es sich beispielsweise um einen Lumineszenzdiodenchip handeln. Bei dem Lumineszenzdiodenchip kann es sich um einen Leucht- oder Laserdiodenchip handeln, der Strahlung im Bereich von ultraviolettem bis infrarotem Licht emittiert. Vorzugsweise emittiert der Lumineszenzdiodenchip Licht im sichtbaren oder ultravioletten Bereich des Spektrums der elektromagnetischen Strahlung.

Gemäß der vorliegenden Erfindung umfasst das optoelektronische Halbleiterbauelement zumindest einen zumindest stellenweise dem Halbleiterchip an seiner Strahlungsauskoppelfläche nachgeordneten strahlungsdurchlässigen Körper, der mit dem Halbleiterchip in zumindest mittelbarem Kontakt steht. Das heißt, dass der strahlungsdurchlässige Körper den Halbleiterchip derart nachgeordnet ist, dass zumindest ein Teil der im Betrieb des Halbleiterchips erzeugten elektromagnetischen Strahlung in den strahlungsdurchlässigen Körper gelangt. "Strahlungsdurchlässig" heißt in diesem Zusammenhang, dass der Körper für von dem strahlungsemittierenden Halbleiterchip emittierte elektromagnetische Strahlung zumindest zu 70 %, bevorzugt zu mehr als 85 %, durchlässig ist. "Mittelbarer Kontakt" heißt, dass zwischen dem strahlungsdurchlässigen Körper und dem Halbleiterchip, beispielsweise seiner Strahlungsauskoppelfläche, eine oder mehrere Schichten angeordnet sein können. Die Schichten beabstanden dann den strahlungsdurchlässigen Körper von dem Halbleiterchip zumindest stellenweise. Mit anderen Worten steht in diesem Fall der strahlungsdurchlässige Körper mit dem Halbleiterchip zumindest stellenweise lediglich über diese Schichten in Kontakt. "Zumindest" bedeutet in Zusammenhang mit "mittelbaren Kontakt", dass der strahlungsdurchlässige Körper mit dem Halbleiterchip, beispielsweise an der Strahlungsauskoppelfläche, zumindest stellenweise auch in unmittelbaren Kontakt stehen kann. In diesem Fall grenzen der strahlungsdurchlässige Körper und der Halbleiterchip direkt aneinander, wobei sich an diesen Stellen weder ein Spalt noch eine Unterbrechung ausbildet.

Gemäß der vorliegenden Erfindung ist der strahlungsdurchlässige Körper mit zumindest einem Polymer gebildet oder enthält zumindest einen Polymer, wobei jeweils ein Monomer des Polymers mit zumindest einem Silazan gebildet ist. Das heißt, dass das Silazan von zumindest einem Monomer des Polymers ein chemischer Grundbaustein und nicht nur ein optionaler, substituierbarer chemischer Zusatzbaustein des Monomers ist. Beispielsweise ist Silazan zur Ausbildung eines Polymers in jedem Monomer des Polymers enthalten. Für den Fall, dass das Polymer ein Copolymer ist, können auch nur ein oder mehrere Monomere einer Monomerart des Polymers mit zumindest einem Silazan gebildet sein. Mit anderen Worten dient das Silazan zur Ausbildung von Polymerisationsketten, welche das Material des strahlungsdurchlässigen Körpers bilden.

Gemäß zumindest einer Ausführungsform umfasst das optoelektronische Halbleiterbauelement zumindest einen strahlungsdurchlässigen Halbleiterchip, der eine Strahlungsauskoppelfläche aufweist, durch die zumindest ein Teil der im Halbleiterchip erzeugten elektromagnetischen Strahlung den Halbleiterchip verlässt. Weiter umfasst das optoelektronische Halbleiterbauelement zumindest einen zumindest stellenweise dem Halbleiterchip an seiner Strahlungsauskoppelfläche nachgeordneten strahlungsdurchlässigen Körper, der mit dem Halbleiterchip in zumindest mittelbarem Kontakt steht. Dabei ist der strahlungsdurchlässige Körper mit zumindest einem Polymer gebildet oder enthält zumindest einen Polymer, wobei jeweils ein Monomer des Polymers mit zumindest einem Silazan gebildet ist.

Das hier beschriebene optoelektronische Halbleiterbauelement beruht dabei unter anderem auf der Erkenntnis, dass ein strahlungsdurchlässiger Körper, welcher einen Halbleiterchip eines Halbleiterbauelements umformt, beispielsweise bereits nach kurzer Betriebsdauer des Halbleiterbauelements Schäden aufweisen kann. Insbesondere kann der strahlungsdurchlässige Körper in der Nähe des Halbleiterchips durch die dort entstehende thermische Erhitzung und/oder auf den strahlungsdurchlässigen Körper einwirkende elektromagnetische Strahlung Schäden aufweisen. Beispielsweise bewirkt von dem Halbleiterchip emittiertes blaues Licht Verfärbungen und/oder Risse in einem solchen strahlungsdurchlässigen Körper. Derartige Schädigungen am strahlungsdurchlässigen Körper können zu einer Verkürzung der Lebensdauer nicht nur des strahlungsdurchlässigen Körpers selbst, sondern des gesamten Halbleiterbauelements führen. Mit anderen Worten ist ein derartiges Halbleiterbauelement wenig alterungsstabil.

Um nun ein optoelektronisches Halbleiterbauelement anzugeben, bei dem derartige Schäden an dem strahlungsdurchlässigen Körper vermieden werden und welches daher alterungsstabil ist, macht das hier beschriebene optoelektronische Halbleiterbauelement unter anderem von der Idee Gebrauch, dass der strahlungsdurchlässige Körper mit zumindest einem Polymer gebildet ist oder zumindest einen Polymer enthält, wobei jeweils ein Monomer des Polymers mit zumindest einem Silazan gebildet ist. Insbesondere weisen Silazane sowohl eine hohe thermische Stabilität als auch eine hohe Stabilität unter Einwirkung von elektromagnetischer Strahlung, beispielsweise bei Einwirkung von blauem Licht auf. Mit anderen Worten werden bei einem mit einem derartigen Material gebildeten strahlungsdurchlässigen Körper die oben beschriebenen Schädigungen während des Betriebs des Halbleiterbauelements vermieden. Dies führt zu einem optoelektronischen Halbleiterbauelement mit einer hohen Alterungsstabilität.

Gemäß zumindest einer Ausführungsform ist das Polymer mit zumindest einem Polysilazan gebildet oder weist zumindest ein Polysilazan auf. Zum Beispiel besteht das Polymer vollständig aus zumindest einem Polysilazan. Zum Beispiel kann ein mit dem hier beschriebenen Polymer gebildetes Material des strahlungsdurchlässigen Körpers, welches zunächst zum Aufbringen in flüssiger oder zähflüssiger Form vorliegt, besonders einfach auf Außenflächen des Halbleiterchips aufgetragen und anschließend zum Beispiel bei einer Zimmertemperatur, also bei etwa 20 °C, zum strahlungsdurchlässigen Körper ausgehärtet werden. Insbesondere kann das Material des strahlungsdurchlässigen Körpers bereits in einem Temperaturbereich von wenigstens Zimmertemperatur und höchstens 220 °C zum strahlungsdurchlässigen Körper aushärten. Mit anderen Worten kann zum Aushärten des Materials auf ein aufwendiges Aufheizen des Materials selbst und/oder des Halbleiterchips verzichtet werden. Eine strukturelle Schädigung des Materials des strahlungsdurchlässigen Körpers und des Halbleiterchips während des Aushärtens kann daher bei derart niedrigen Aushärttemperaturen vermieden werden. Gemäß zumindest einer Ausführungsform ist in den strahlungsdurchlässigen Körper zumindest ein Lumineszenzkonversionsmaterial eingebracht, das zur Absorption von elektromagnetischer Strahlung eines Wellenlängenbereichs und zur Reemission der absorbierten elektromagnetischen Strahlung in einem anderen Wellenlängenbereich mit größeren Wellenlängen als die absorbierte Strahlung geeignet ist. Beispielsweise wandelt das Lumineszenzkonversionsmaterial von dem Halbleiterchip emittiertes und in den strahlungsdurchlässigen Körper eintretendes blaues Licht teilweise in gelbes Licht um, das sich dann zusammen mit dem blauen Licht zu weißem Licht vermischen kann.

Gemäß der vorliegenden Erfindung weist der strahlungsdurchlässige Körper Spuren eines Materialabtrags auf. Das heißt, dass der strahlungsdurchlässige Körper nach dem Aufbringen und dem anschließenden Aushärten physikalisch und/oder mechanisch nachbearbeitet und dadurch der Materialabtrag erzeugt ist. Mit anderen Worten, lässt sich der hier beschriebene strahlungsdurchlässige Körper auch erst nach dem vollständigen Aushärten mechanisch, beispielsweise durch Schleifen und/oder Polieren, nachbearbeiten, ohne dass beispielweise eine klebrige Außenfläche des strahlungsdurchlässigen Körpers ein derartiges Nachbearbeiten zumindest erschwert oder ganz verhindert. Dies führt zu einem besonders individuell und flexibel einsetzbaren optoelektronischen Halbleiterbauelement, da der strahlungsdurchlässige Körper auch erst nach dem Aufbringen und anschließendem Aushärten den individuellen Bedürfnissen des Benutzers angepasst werden kann.

Gemäß zumindest einer Ausführungsform enthält der strahlungsdurchlässige Körper zumindest ein Lösungsmittel und/oder zumindest ein Thixotropierungsmittel. Zum Beispiel liegt ein Material des strahlungsdurchlässigen Körpers, bevor dieses zum strahlungsdurchlässigen Körper selbst aushärten kann, in flüssiger oder zähflüssiger Form vor. Durch die Zugabe eines Lösungsmittels in das Material kann je nach Konzentration des Lösungsmittels im Material beispielsweise eine Viskosität des Materials des strahlungsdurchlässigen Körpers vorgebbar eingestellt werden. Dabei kann die Zugabe eines Lösungsmittels zu einer Steigerung in der Viskosität des Materials, das heißt zu einer Verflüssigung, des Materials des strahlungsdurchlässigen Körpers führen, wohingegen die Zugabe des Thixotropierungsmittels zum Material des strahlungsdurchlässigen Körpers zu einem Material führen kann, welches vor dem Aufbringen in zähflüssiger Form, beispielsweise pastenartig, ist.

Gemäß zumindest einer Ausführungsform ist der strahlungsdurchlässige Körper ein Formkörper, der den Halbleiterchip zumindest stellenweise formschlüssig umhüllt. In diesem Fall kann der Formkörper mittels beispielsweise Vergießen oder Molding des Halbleiterchips erzeugt sein. Insbesondere grenzen dann der Halbleiterchip und der strahlungsdurchlässige Körper direkt aneinander.

Gemäß der vorliegenden Erfindung ist der strahlungsdurchlässige Körper ein Plättchen oder eine Folie, wobei zwischen dem strahlungsdurchlässigen Körper und der Strahlungsauskoppelfläche zumindest eine strahlungsdurchlässige Anhaftschicht angeordnet ist. Ist der strahlungsdurchlässige Körper ein Plättchen, ist dieses vorzugsweise selbsttragend ausgebildet. In diesem Fall kann der strahlungsdurchlässige Körper beispielsweise mittels eines Pick-and-Place-Verfahrens auf einer dem Halbleiterchip abgewandten Außenfläche der Anhaftschicht aufgebracht sein. Handelt es sich bei dem strahlungsdurchlässigen Körper um eine Folie, kann in diesem Fall der strahlungsdurchlässige Körper flexibel sein und beispielsweise auf die dem Halbleiterchip abgewandte Außenfläche der Anhaftschicht mittels Laminieren aufgebracht sein. Die Anhaftschicht ermöglicht eine mechanisch feste Verbindung zwischen dem Halbleiterchip und dem strahlungsdurchlässigen Körper. Mit anderen Worten können mittels der Anhaftschicht der strahlungsdurchlässige Körper und der Halbleiterchip zusammenhängend ausgebildet sein und eine Einheit bilden.

Gemäß der vorliegenden Erfindung weist die strahlungsdurchlässige Anhaftschicht zumindest ein Polysilazan auf oder besteht aus zumindest einem Polysilazan. Für den Fall, dass die Anhaftschicht aus zumindest einem Polysilazan besteht, ist diese frei von Fremdpartikeln. "Frei von Fremdpartikeln" heißt, dass im Rahmen einer Fertigungstoleranz in die Anhaftschicht nicht vorgebbar Partikel eines Fremdstoffes eingebracht sind. In diesem Fall weist die Anhaftschicht weder das hier beschriebene Lumineszenzkonversionsmaterial noch beispielsweise andere Fremdpartikel auf. Wie bereits oben beschrieben wird durch die Anhaftschicht eine mechanisch feste Verbindung zwischen dem strahlungsdurchlässigen Körper und dem Halbleiterchip ausgebildet. Ist nun die Anhaftschicht mit Polysilazan gebildet, weist ein Polysilazan auf oder besteht aus Polysilazan, so ist die ausgebildete mechanische Verbindung hinsichtlich der Lichtstreuung und thermischen Stabilität besonders vorteilhaft ausgebildet. Zum Beispiel wird durch die Verwendung von Polysilazan für die Anhaftschicht und dem strahlungsdurchlässigen Körper ein Material mit gleichem Brechungsindex verwendet, sodass das emittierte Licht des Halbleiterchips keinen unterschiedlichen Brechungsindices unterworfen ist. Des Weiteren bilden Polymere bestehend aus dem gleichen Ausgangsmaterial thermisch besonders stabile Verbindungen aus.

In einem nicht erfindungsgemäßen Beispiel ist der strahlungsdurchlässige Körper verbindungsmittelfrei zumindest auf die Strahlungsauskoppelfläche des Halbleiterchips mittels Siebdruck und/oder Sprühen aufgebracht. "Verbindungsmittelfrei" heißt, dass der strahlungsdurchlässige Körper keiner Befestigungsmittel, beispielsweise einer zusätzlichen Anhaftschicht oder einem Klebstoff, zur Befestigung auf dem Halbleiterchip bedarf. Zum Beispiel bedeckt der strahlungsdurchlässige Körper neben der Strahlungsauskoppelfläche weitere freiliegende Außenflächen des Halbleiterchips. In diesem Fall kann der strahlungsdurchlässige Körper auch als eine Versiegelung für den Halbleiterchip dienen. Zudem ist denkbar, dass neben dem Aufbringen mittels Siebdruck und/oder Sprühens der strahlungsdurchlässige Körper mittels Rollen oder Aufschleuderns auf den Halbleiterchip aufgebracht ist.

Gemäß zumindest einer Ausführungsform weist der strahlungsdurchlässige Körper und/oder die Anhaftschicht eine Schichtdicke von wenigstens 5 µm und höchstens 50 µm auf. "Schichtdicke" ist dabei eine Dicke des strahlungsdurchlässigen Körpers und/oder der Anhaftschicht in einer Richtung senkrecht zu der Strahlungsauskoppelfläche und/oder zu weiteren Außenflächen des Halbleiterchips. Durch einen derartigen Dickenbereich des strahlungsdurchlässigen Körpers und/oder der Anhaftschicht kann ein optoelektronisches Halbleiterbauelement erreicht werden, welches eine geringe Ausdehnung in vertikaler Richtung, das heißt in einer Richtung senkrecht zur Haupterstreckungsrichtung des optoelektronischen Halbleiterbauelements, aufweist. Mit anderen Worten ist ein derartiges optoelektronisches Halbleiterbauelement flach und kompakt im Aufbau.

Im Folgenden wird das hier beschriebene optoelektronische Halbleiterbauelement anhand von Ausführungsbeispielen und den dazugehörigen Figuren näher erläutert.

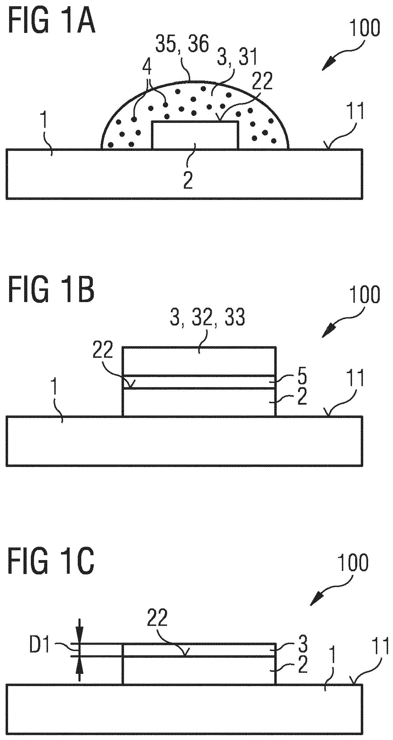

Die Figuren 1A und 1C zeigen in schematischen Seitenansichten Beispiele eines hier beschriebenen optoelektronischen Halbleiterbauelements.

Die Figur 1B zeigt in einer schematischen Seitenansicht ein Ausführungsbeispiel eines erfindungsgemäßen optoelektronischen Halbleiterbauelements.

In den Ausführungsbeispielen und den Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

In der Figur 1A ist anhand einer schematischen Seitenansicht ein hier beschriebenes optoelektronisches Halbleiterbauelement 100 dargestellt. Das optoelektronische Halbleiterbauelement 100 umfasst einen strahlungsemittierenden Halbleiterchip 2, der eine Strahlungsauskoppelfläche 22 aufweist, durch die zumindest ein Teil der im Halbleiterchip 2 erzeugten elektromagnetischen Strahlung den Halbleiterchip 2 verlässt. Weiter umfasst das optoelektronische Halbleiterbauelement 100 einen Träger 1, der eine Montagefläche 11 aufweist. Bei dem Träger 1 kann es sich um einen Trägerrahmen (zu engl. auch Leadframe) handeln. Der Trägerrahmen kann dann mit zwei metallischen Trägerstreifen gebildet sein, die als elektrische Kontaktflächen für den Halbleiterchip 2 dienen. Dabei ist der Halbleiterchip 2 auf der Montagefläche 11 angeordnet und dort elektrisch mit dem Träger 1 kontaktiert. Weiter umfasst das optoelektronische Halbleiterbauelement 100 einen strahlungsdurchlässigen Körper 3, der in der Figur 1A als ein Formkörper 31 ausgeführt ist. Das heißt, dass der strahlungsdurchlässige Körper 3 mittels Vergießens des Halbleiterchips 2 sowohl auf dem Träger 1 als auch dem Halbleiterchip 2 aufgebracht ist. Dabei steht der strahlungsdurchlässige Körper 3 in unmittelbaren Kontakt mit dem Halbleiterchip 3 und dem Träger 1. Der strahlungsdurchlässige Körper 3 umhüllt daher den Halbleiterchip 2 formschlüssig und steht stellenweise mit der Montagefläche 11 des Trägers 1 in direktem Kontakt. Dabei ist, wie ebenso der Figur 1A entnehmbar, der strahlungsdurchlässige Körper 3 stellenweise dem Halbleiterchip 2 an seiner Strahlungsauskoppelfläche 22 nachgeordnet und steht mit der Strahlungsauskoppelfläche 22 in direktem Kontakt.

Der strahlungsdurchlässige Körper 3 ist mit zumindest einem Polymer gebildet oder enthält zumindest ein Polymer, wobei jeweils ein Monomer des Polymers mit zumindest einem Silazan gebildet ist. Insbesondere kann es sich bei dem Polymer um ein Polysilazan handeln. Weiter ist in dem strahlungsdurchlässigen Körper 3 ein Lumineszenzkonversionsmaterial 4 eingebracht, welches vom Halbleiterchip 2 emittiertes blaues Licht teilweise in gelbes Licht umwandelt, wobei sich das blaue und das gelbe Licht zum Beispiel an einer dem Träger 1 abgewandten Außenfläche 36 des strahlungsdurchlässigen Körpers 3 zu weißem Licht vermischen kann. Weiter ist die Außenfläche 36 des strahlungsdurchlässigen Körpers 3 in Bezug auf den Halbleiterchip 2 konvex ausgeformt. Dazu ist der strahlungsdurchlässige Körper 3 nach dem Aushärten mechanisch nachbearbeitet, wobei durch das Nachbearbeiten die Außenfläche 36 Spuren 35 eines Materialabtrags aufweist. Mit anderen Worten sind die Spuren 35 durch Abtragung, zum Beispiel Materialabrieb, des Materials des strahlungsdurchlässigen Körpers 3 in seiner Außenfläche 36 erzeugt.

In der Figur 1B ist in einer schematischen Seitenansicht ein Ausführungsbeispiel eines hier beschriebenen optoelektronischen Halbleiterbauelements 100 gezeigt. Im Unterschied zu dem in der Figur 1A gezeigten Beispiel handelt es sich nun bei dem strahlungsdurchlässigen Körper 3 um ein Plättchen 32 oder um eine Folie 33, wobei zwischen dem strahlungsdurchlässigen Körper 3 und der Strahlungsauskoppelfläche 22 des Halbleiterchips 2 eine strahlungsdurchlässige Anhaftschicht 5 angeordnet ist. Insbesondere kann die Anhaftschicht 5 mit zumindest einem Polysilazan gebildet sein, ein Polysilazan aufweisen oder aus einem Polysilazan bestehen. Dabei ist die strahlungsdurchlässige Anhaftschicht 5 direkt auf die Strahlungsauskoppelfläche 22 des Halbleiterchips 2 aufgebracht und steht damit in direktem Kontakt mit diesem. Auf eine dem Halbleiterchip 2 abgewandte Außenfläche der strahlungsdurchlässigen Anhaftschicht 5 ist der strahlungsdurchlässige Körper 3 beispielsweise mittels eines Plug-and-Place-Verfahrens angeordnet. Die Anhaftschicht 5 ermöglicht eine mechanisch feste Verbindung zwischen Halbleiterchip 2 und dem strahlungsdurchlässigen Körper 3. Mit anderen Worten ist in dem Ausführungsbeispiel gemäß der Figur 1B der strahlungsdurchlässige Körper 3 über die strahlungsdurchlässige Anhaftschicht 5 mit dem strahlungsemittierenden Halbleiterchip 2 in mittelbarem Kontakt.

In der Figur 1C ist in einer schematischen Seitenansicht ein nicht erfindungsgemäßes Beispiel eines optoelektronischen Halbleiterbauelements 100 gezeigt. Dabei ist im Gegensatz zu der Figur 1B der strahlungsdurchlässige Körper 3 verbindungsmittelfrei auf die Strahlungsauskoppelfläche 22 des Halbleiterchips 2 aufgebracht und steht mit der Strahlungsauskoppelfläche 22 in unmittelbaren Kontakt. Beispielsweise geschieht das Aufbringen mittels Siebdruck und/oder Sprühen des Materials des strahlungsdurchlässigen Körpers 3 auf die Strahlungsauskoppelfläche 22. Dabei weist der strahlungsdurchlässige Körper 3 in dem Beispiel gemäß der Figur 1C eine Schichtdicke D1 von wenigstens 5 µm und höchstens 50 µm auf.

## Patentansprüche

1. Optoelektronisches Halbleiterbauelement (100), mit
- zumindest einem strahlungsemittierenden Halbleiterchip (2), der eine Strahlungsauskoppelfläche (22) aufweist, durch die zumindest ein Teil der im Halbleiterchip (2) erzeugten elektromagnetischen Strahlung den Halbleiterchip (2) verlässt;
- zumindest einem zumindest stellenweise dem Halbleiterchip (2) an seiner Strahlungsauskoppelfläche (22) nachgeordneten strahlungsdurchlässigen Körper (3), der mit dem Halbleiterchip (2) in zumindest mittelbarem Kontakt steht, wobei
- der strahlungsdurchlässige Körper (3) Spuren (35) eines physikalisch und/oder mechanischen Materialabtrags aufweist,
- der strahlungsdurchlässige Körper (3) ein Plättchen (32) oder eine Folie (33) ist,
- zwischen und jeweils in direktem Kontakt mit dem strahlungsdurchlässigen Körper (3) und der Strahlungsauskoppelfläche (22) zumindest eine strahlungsdurchlässige Anhaftschicht (5) angeordnet ist, und
- die strahlungsdurchlässige Anhaftschicht (5) zumindest ein Polysilazan aufweist oder aus einem Polysilazan besteht, und
- der strahlungsdurchlässige Körper (3) zumindest einen Polymer enthält, und
- jeweils ein Monomer des Polymers zumindest ein Silazan enthält.

2. Optoelektronisches Halbleiterbauelement (100) nach einem der vorhergehenden Ansprüche,
bei dem das Polymer zumindest ein Polysilazan aufweist.

3. Optoelektronisches Halbleiterbauelement (100) nach einem der vorhergehenden Ansprüche,
bei dem in den strahlungsdurchlässigen Körper (3) zumindest ein Lumineszenzkonversionsmaterial (4) eingebracht ist, das zur Absorption von elektromagnetischer Strahlung eines Wellenlängenbereichs und zur Reemission der absorbierten elektromagnetischen Strahlung in einem anderen Wellenlängenbereich mit größeren Wellenlängen als die absorbierte Strahlung geeignet ist.

4. Optoelektronisches Halbleiterbauelement (100) nach dem vorhergehenden Anspruch, wobei die Anhaftschicht (5) im Rahmen einer Fertigungstoleranz frei von dem Lumineszenzkonversionsmaterial (4) ist.

5. Optoelektronisches Halbleiterbauelement (100) nach einem der vorhergehenden Ansprüche,
bei dem der strahlungsdurchlässige Körper (3) zumindest ein Lösungsmittel und/oder zumindest ein Thixotropierungsmittel enthält.

6. Optoelektronisches Halbleiterbauelement (100) nach einem der vorhergehenden Ansprüche,
bei dem der strahlungsdurchlässige Körper (3) ein Formkörper (31) ist, der den Halbleiterchip (2) zumindest stellenweise formschlüssig umhüllt.

7. Optoelektronisches Halbleiterbauelement (100) nach einem der vorhergehenden Ansprüche,
bei dem der strahlungsdurchlässige Körper (3) und/oder die Anhaftschicht (5) eine Schichtdicke (D1) von wenigstens 5 µm und höchstens 50 µm aufweisen.

8. Optoelektronisches Halbleiterbauelement (100) nach einem der vorhergehenden Ansprüche, wobei der strahlungsdurchlässige Körper (3) ein Plättchen (32) ist, welches selbsttragend ausgebildet ist.

9. Optoelektronisches Halbleiterbauelement (100) nach einem der Ansprüche 1 bis 7, wobei der strahlungsdurchlässige Körper (3) eine Folie (33) ist, die flexibel ist.

10. Optoelektronisches Halbleiterbauelement (100) nach einem der vorhergehenden Ansprüche, wobei eine Außenfläche (36) des strahlungsdurchlässigen Körpers (3) in Bezug auf den Halbleiterchip (2) konvex ausgeformt ist.

## Claims

1. An optoelectronic semiconductor component (100), having
- at least one radiation-emitting semiconductor chip (2), which comprises a radiation-outcoupling face (22), through which at least some of the electromagnetic radiation generated in the semiconductor chip (2) leaves the semiconductor chip (2);
- at least one radiation-transmissive body (3) arranged at least in places downstream of the semiconductor chip (2) on its radiation-outcoupling face (22), which body is in at least indirect contact with the semiconductor chip (2), wherein
- the radiation-transmissive body (3) comprises traces (35) of a physical and/or mechanical material removal,
- the radiation-transmissive body (3) is a lamina (32) or a foil (33),
- at least one radiation-transmissive adhesion layer (5) is arranged between and respectively in direct contact with the radiation-transmissive body (3) and the radiation-outcoupling face (22), and
- the radiation-transmissive adhesion layer (5) comprises at least one polysilazane or consists of a polysilazane, and
- the radiation-transmissive body (3) contains at least one polymer, and
- in each case one monomer of the polymer contains at least one silazane.

2. The optoelectronic semiconductor component (100) according to any one of the preceding claims, in which the polymer comprises at least one polysilazane.

3. The optoelectronic semiconductor component (100) according to any one of the preceding claims,
in which at least one luminescence conversion material (4) is introduced into the radiation-transmissive body (3), which is suitable for absorbing electromagnetic radiation of one wavelength range and re-emitting the absorbed electromagnetic radiation in another wavelength range with larger wavelengths than the absorbed radiation.

4. The optoelectronic semiconductor component (100) according to the preceding claim, wherein the adhesion layer (5) is free of luminescence conversion material (4) within the limits of manufacturing tolerance.

5. The optoelectronic semiconductor component (100) according to any one of the preceding claims,
in which the radiation-transmissive body (3) contains at least one solvent and/or at least one thixotroping agent.

6. The optoelectronic semiconductor component (100) according to any one of the preceding claims,
in which the radiation-transmissive body (3) is a mold (31), which envelops the semiconductor chip (2) in form-fitting manner at least in places.

7. The optoelectronic semiconductor component (100) according to any one of the preceding claims,
in which the radiation-transmissive body (3) and/or the adhesion layer (5) exhibits a layer thickness (D1) of at least 5 µm and at most 50 µm.

8. The optoelectronic semiconductor component (100) according to any one of the preceding claims, wherein the radiation-transmissive body (3) is a lamina (32) which is shaped in a self-supporting manner.

9. The optoelectronic semiconductor component (100) according to claims 1 to 7, wherein the radiation-transmissive body (3) is a foil (33) which is flexible.

10. The optoelectronic semiconductor component (100) according to any one of the preceding claims, wherein an outer surface (36) of the radiation-transmissive body (3) formed in a convex manner with respect to the semiconductor chip (2).

## Revendications

1. Composant semi-conducteur optoélectronique (100), comportant
- au moins une puce semi-conductrice émettrice de rayonnement (2) comportant une surface de découplage de rayonnement (22) à travers laquelle au moins une partie du rayonnement électromagnétique généré dans la puce semi-conductrice (2) quitte la puce semi-conductrice (2) ;
- au moins un corps (3) perméable au rayonnement disposé, au moins par endroits, en aval de la surface de découplage de rayonnement (22) de la puce semi-conductrice (2) qui est au moins en contact indirect avec la puce semi-conductrice (2),
- le corps (3) perméable au rayonnement présentant des traces (35) d'enlèvement physique ou mécanique de matière,
- le corps perméable au rayonnement (3) étant une plaquette (32) ou un film (33),
- au moins une couche adhésive (5) perméable au rayonnement étant disposée entre, et respectivement en contact direct avec celui-ceux, le corps (3) perméable au rayonnement et la surface de découplage de rayonnement (22), et
- la couche adhésive (5) perméable au rayonnement comprenant au moins un polysilazane ou consistant en un polysilazane, et
- le corps (3) perméable au rayonnement contenant au moins un polymère, et
- un monomère du polymère chacun contenant au moins un silazane.

2. Composant semi-conducteur optoélectronique (100) selon l'une des revendications précédentes,
dans lequel le polymère comporte au moins un polysilazane.

3. Composant semi-conducteur optoélectronique (100) selon l'une des revendications précédentes,
dans lequel au moins un matériau de conversion de luminescence (4) est incorporé au corps (3) perméable au rayonnement, ce premier étant apte à absorber du rayonnement électromagnétique d'une gamme de longueurs d'onde et à réémettre le rayonnement électromagnétique absorbé dans une autre gamme de longueurs d'onde plus élevées que le rayonnement absorbé.

4. Composant optoélectronique (100) selon la revendication précédente, dans lequel
la couche adhésive (5) est exempte de matériau de conversion de luminescence (4) dans le cadre d'une tolérance de fabrication.

5. Composant semi-conducteur optoélectronique (100) selon l'une des revendications précédentes,
dans lequel le corps (3) perméable au rayonnement contient au moins un solvant et / ou au moins un agent thixotrope.

6. Composant semi-conducteur optoélectronique (100) selon l'une des revendications précédentes,
dans lequel le corps (3) perméable au rayonnement est un corps moulé (31) qui entoure positivement la puce semi-conductrice (2) au moins par endroits.

7. Composant semi-conducteur optoélectronique (100) selon l'une des revendications précédentes,
dans lequel le corps (3) perméable au rayonnement et / ou la couche adhésive (5) présentent une épaisseur (D1) d'au moins 5 µm et de 50 µm au maximum.

8. Composant semi-conducteur optoélectronique (100) selon l'une des revendications précédentes, dans lequel le corps (3) perméable au rayonnement est une plaquette(32) prévue sous forme autoportante.

9. Composant semi-conducteur optoélectronique (100) selon l'une des revendications 1 à 7, dans lequel le corps (3) perméable au rayonnement est un film (33) flexible.

10. Composant semi-conducteur optoélectronique (100) selon l'une des revendications précédentes, dans lequel une surface extérieure (36) du corps (3) perméable au rayonnement est convexe par rapport à la puce semi-conductrice (2).
